(19) **Europäisches Patentamt**
**European Patent Office**
**Office européen des brevets**

(11) **EP 4 503 487 A1**

(12) **EUROPEAN PATENT APPLICATION**
published in accordance with Art. 153(4) EPC

(43) Date of publication:
**05.02.2025 Bulletin 2025/06**

(21) Application number: **23791196.1**

(22) Date of filing: **17.04.2023**

(51) International Patent Classification (IPC):
**H04L 1/16** (2023.01)

(52) Cooperative Patent Classification (CPC):
**H04L 1/00; H04L 1/16; H04L 1/1607**

(86) International application number:
**PCT/CN2023/088784**

(87) International publication number:
**WO 2023/202541 (26.10.2023 Gazette 2023/43)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **22.04.2022 CN 202210431800**

(71) Applicant: **Huawei Technologies Co., Ltd.
Shenzhen, Guangdong 518129 (CN)**

(72) Inventors:
• **LI, Bin
Shenzhen, Guangdong 518129 (CN)**
• **ZHANG, Huazi
Shenzhen, Guangdong 518129 (CN)**
• **GU, Jiaqi
Shenzhen, Guangdong 518129 (CN)**
• **WANG, Xianbin
Shenzhen, Guangdong 518129 (CN)**

(74) Representative: **Epping - Hermann - Fischer
Patentanwaltsgesellschaft mbH
Schloßschmidstraße 5
80639 München (DE)**

(54) **INFORMATION TRANSMISSION METHOD AND APPARATUS**

(57) This application provides an information transmission method and an apparatus and relates to the field of wireless communication technologies, to reduce an amount of retransmitted data and reduce transmission overheads. In the method, a sending device sends a first bit sequence to a receiving device. Optionally, the first bit sequence is an information bit sequence, or the first bit sequence is an information bit sequence obtained through first encoding. The sending device receives a second bit sequence from the receiving device. The sending device sends a first code block to the receiving device, where the first code block is obtained based on a first error pattern and a first check matrix. The first error pattern is determined based on the second bit sequence and the first bit sequence. According to the foregoing solution, the sending device may determine and obtain the first error pattern that is in previous transmission, and the sending device adaptively adjusts a data amount of retransmitted data by using the first error pattern. In comparison with a current retransmission solution, the data amount in retransmission can be reduced, channel utilization can be improved, and transmission overheads can be reduced.

FIG. 3

**Description**

**CROSS-REFERENCE TO RELATED APPLICATIONS**

This application claims priority to Chinese Patent Application No. 202210431800.3, filed with the China National Intellectual Property Administration on April 22, 2022 and entitled "INFORMATION TRANSMISSION METHOD AND APPARATUS", which is incorporated herein by reference in its entirety.

**TECHNICAL FIELD**

This application relates to the field of wireless communication technologies, and in particular, to an information transmission method and an apparatus.

**BACKGROUND**

Currently, whether data retransmission needs to be performed between a sending device and a receiving device may be determined based on an acknowledgment (acknowledgment, ACK)/a negative acknowledgment (non-acknowledgment, NACK). For example, the sending device may send data to the receiving device. The receiving device sends feedback information to the sending device. The feedback information is a 1-bit ACK/NACK. For example, if the receiving device cannot correctly decode the data, the feedback information may be a NACK. If the receiving device can correctly decode the data, an amount is fixed, and a data amount of current retransmitted data is the same as a data amount of initially transmitted data. In other words, the initially transmitted data needs to be retransmitted each time transmission fails. Consequently, additional transmission overheads are caused.

**SUMMARY**

This application provides an information transmission method and an apparatus, to reduce an amount of retransmitted data and reduce transmission overheads.

According to a first aspect, an information transmission method is provided. The method may be performed by a sending device or a chip having a function similar to that of a sending device. Optionally, the sending device may be a network device or a terminal device. In the method, the sending device sends a first bit sequence to a receiving device. Optionally, the first bit sequence is an information bit sequence, or the first bit sequence is an information bit sequence obtained through first encoding. The sending device receives a second bit sequence from the receiving device. The sending device sends a first code block to the receiving device, where the first code block is obtained based on a first error pattern and a first check matrix. The first error pattern is determined based on the second bit sequence and the first bit sequence.

According to the foregoing solution, the receiving device may send the second bit sequence to the sending device. In comparison with a current solution, information fed back by the receiving device is no longer limited to an ACK or a NACK. When capacity of a feedback channel is large enough, in the foregoing solution, the sending device may determine and obtain the first error pattern that is in previous transmission, and the sending device adaptively adjusts a data amount of retransmitted data by using the first error pattern. In comparison with a current retransmission solution, a data amount in retransmission can be reduced, channel utilization can be improved, and transmission overheads can be reduced.

In a possible implementation, the second bit sequence is obtained based on a second check matrix.

In an example, the second bit sequence is generated based on the second check matrix and a third bit sequence. Optionally, the third bit sequence is a first bit sequence received by the receiving device. The third bit sequence may be the same as or different from the first bit sequence.

In an example, when the first bit sequence is different from the third bit sequence, the sending device receives the second bit sequence from the receiving device.

According to the foregoing solution, the receiving device may generate the second bit sequence based on the second check matrix, so that the receiving device can send the second bit sequence to the sending device. Therefore, the sending device may determine the first error pattern in the previous transmission.

In a possible implementation, the first error pattern is obtained by decoding a second code block X based on the second check matrix, where $X = V + (U_1 \cdot G_v + U_2)$, $U_1$ and $U_2$ are subsequences of the first bit sequence U, a length of U is N, a length of $U_2$ is N2, a length of $U_1$ is N1, N=N1+N2, a dimension of $G_v$ is N1×N2, $G_v$ is a generator matrix, and V is the second bit sequence.

According to the foregoing solution, the sending device may construct a syndrome X of the first error pattern, and may perform a decoding operation on the syndrome X of the first error pattern, so that the sending device can determine the first error pattern in the previous transmission.

In a possible implementation, the first code block is $W = E \cdot H_w$, where $H_w$ is the first check matrix, and E is the first error pattern.

According to the foregoing solution, the sending device may send the first code block to the receiving device. Because the first code block is obtained based on the first check matrix $H_w$ and the first error pattern E, the receiving device may determine, based on the first code block, the error pattern in the previous transmission, and correct an error of the received first bit sequence.

In a possible implementation, the sending device receives a third code block from the receiving device. The sending device sends a check bit sequence to the receiving device, where the check bit sequence is obtained based on a second error pattern and a fourth check matrix, where the second error pattern is obtained based on the first code block and the third code block.

According to the foregoing solution, the receiving device may send the third code block to the sending device, so that the sending device can determine and obtain the second error pattern in the previous transmission, namely, an error pattern of the first code block. The sending device adaptively adjusts, by using the second error pattern, a data amount of data to be retransmitted next time, namely, the check bit sequence. This can reduce the data amount in the retransmission, improve the channel utilization, and reduce the transmission overheads.

In a possible implementation, the check bit sequence is a check bit sequence in the first code block. According to the foregoing solution, because the check bit sequence is a check bit sequence in the first code block, the check bit sequence may be used to correct an error of the first code block. In other words, the receiving device may correct the error of the first code block based on the check bit sequence. Therefore, the receiving device may determine the first error pattern based on a corrected first code block, to correct the error of the received first bit sequence. According to the foregoing retransmission solution, performance of approaching channel capacity limit can be achieved when a code length is short.

In a possible implementation, the third code block is obtained based on a fifth check matrix.

In an example, the third code block may be obtained based on the fifth check matrix and a fourth code block. Optionally, the fourth code block may be a first code block received by the receiving device. The fourth code block may be the same as or different from the first code block.

In an example, when the fourth code block is different from the first code block, the sending device receives the third code block from the receiving device.

According to the foregoing solution, the receiving device may obtain the third code block based on the fifth check matrix, and send the third code block to the sending device. In this way, the sending device may determine, based on the third code block, whether the first code block is correctly received, and the sending device may also determine the second error pattern of the first code block.

In a possible implementation, when the first bit sequence is an information bit sequence obtained through first encoding, the first code block is obtained based on the first error pattern, the first check matrix, and an error correction capability of the first encoding.

Optionally, when a quantity of errors indicated by the first error pattern is the same as a quantity of errors indicated by the error correction capability of the first encoding, the sending device may not send the first code block.

According to the foregoing solution, the sending device may adjust, based on the first check matrix, the first error pattern, and the error correction capability of the first encoding, a size of a first code block in retransmission, and incrementally send, to the receiving device, the first code block used for error correction. In this way, the transmission overheads can be reduced, and the performance of approximating the channel capacity can be achieved when the code length is short.

In a possible implementation, the first check matrix is a generator matrix of a Bose Ray-Chaudhuri Hocquenghem (bose ray-chaudhuri hocquenghem, BCH) code.

In a possible implementation, the first encoding is one of the following: cyclic redundancy check (cyclic redundancy check, CRC) encoding, BCH encoding, Reed-Solomon code (reed solomon code, RS) encoding, Reed-Muller (reed-muller, RM) encoding, polar code encoding, and low-density parity check (low density parity check code, LDPC) encoding.

According to a second aspect, an information transmission method is provided. The method may be performed by a receiving device or a chip having a function similar to that of a receiving device. In the method, the receiving device receives a third bit sequence from a sending device. Optionally, the third bit sequence is an information bit sequence, or the third bit sequence is an information bit sequence obtained through first encoding. The receiving device sends a second bit sequence to the sending device. The receiving device receives a fourth code block from the sending device, where the fourth code block is obtained based on a first error pattern and a first check matrix. The first error pattern is determined based on the second bit sequence.

According to the foregoing solution, the receiving device may send the second bit sequence to the sending device. In comparison with a current solution, information fed back by the receiving device is no longer limited to an ACK or a NACK. When capacity of a feedback channel is large enough, in the foregoing solution, the sending device may determine and obtain the first error pattern that is in previous transmission, and the sending device adaptively adjusts a data amount of retransmitted data by using the first error pattern. In comparison with a current retransmission solution, a data amount in retransmission can be reduced, channel utilization can be improved, and transmission overheads can be reduced.

In a possible implementation, the second bit sequence is obtained based on a second check matrix.

In an example, the second bit sequence is generated based on the second check matrix and the third bit sequence.

In an example, when a first bit sequence is different from the third bit sequence, the receiving device sends the second bit sequence to the sending device. Optionally, the first bit sequence is a third bit sequence sent by the sending device. The third bit sequence may be the same as or different from the first bit sequence.

According to the foregoing solution, the receiving device may generate the second bit sequence based on the second check matrix, so that the receiving device can send the second bit sequence to the sending device. Therefore, the sending device may determine the first error pattern in the previous transmission.

In a possible implementation, the receiving device decodes the fourth code block based on the first check matrix, to obtain the first error pattern. The receiving device corrects the third bit sequence based on the first error pattern.

According to the foregoing solution, after decoding the fourth code block, the receiving device may obtain the first error pattern, namely, the error pattern in the previous transmission. Therefore, the receiving device may perform an error correction operation on the third bit sequence in the previous transmission.

In a possible implementation, the receiving device sends a third code block to the sending device. The receiving device receives a check bit sequence from the sending device, where the check bit sequence is obtained based on a second error pattern and a fourth check matrix, where the second error pattern is obtained based on the fourth code block and the third code block.

According to the foregoing solution, the receiving device may send the third code block to the sending device, so that the sending device can determine and obtain the second error pattern in the previous transmission, namely, an error pattern of the first code block. The sending device adaptively adjusts, by using the second error pattern, a data amount of data to be retransmitted next time, namely, the check bit sequence. This can reduce the data amount in the retransmission, improve the channel utilization, and reduce the transmission overheads.

In a possible implementation, the check bit sequence is a check bit sequence in the fourth code block. According to the foregoing solution, because the check bit sequence is a check bit sequence in the fourth code block, the check bit sequence may be used to correct an error of the fourth code block. In other words, the receiving device may correct the error of the fourth code block based on the check bit sequence. Therefore, the receiving device may determine the first error pattern based on a corrected fourth code block, to correct an error of the received third bit sequence. According to the foregoing retransmission solution, performance of approximating channel capacity can be achieved when a code length is short.

In a possible implementation, the receiving device corrects the error of the fourth code block based on the check bit sequence.

In a possible implementation, the third code block is obtained based on a fifth check matrix.

In an example, the third code block may be obtained based on the fifth check matrix and the fourth code block.

In an example, when the fourth code block is different from the first code block, the receiving device sends the third code block to the sending device. Optionally, the first code block may be a fourth code block sent by the sending device. The fourth code block may be the same as or different from the first code block.

According to the foregoing solution, the receiving device may obtain the third code block based on the fifth check matrix, and send the third code block to the sending device. In this way, the sending device may determine, based on the third code block, whether the first code block is correctly received, and the sending device may also determine the second error pattern of the first code block.

In a possible implementation, when the third bit sequence is an information bit sequence obtained through first encoding, the first code block is obtained based on the first error pattern, the first check matrix, and an error correction capability of the first encoding.

Optionally, when a quantity of errors indicated by the first error pattern is the same as a quantity of errors indicated by the error correction capability of the first encoding, the receiving device may not receive the first code block.

According to the foregoing solution, the sending device may adjust, based on the first check matrix, the first error pattern, and the error correction capability of the first encoding, a size of a first code block in retransmission, and incrementally send, to the receiving device, the first code block used for error correction. In this way, the transmission overheads can be reduced, and the performance of approximating the channel capacity can be achieved when the code length is short.

In a possible implementation, the first check matrix is a check matrix of a BCH code.

In a possible implementation, the first encoding is one of the following: CRC encoding, BCH encoding, RS encoding, RM, polar code encoding, and LDPC encoding.

According to a third aspect, a communication apparatus is provided, and includes a processing unit and a transceiver unit. The transceiver unit is configured to send a first bit sequence to a receiving device. The first bit sequence is an information bit sequence, or the first bit sequence is an information bit sequence obtained through first encoding. The transceiver unit is further configured to receive a second bit sequence from the receiving device. The processing unit is configured to generate a first code block based on a first error pattern and a first check matrix, where the first error pattern is determined based on the second bit sequence and the first bit sequence. The transceiver unit is further configured to send the first code block to the receiving device.

In a possible implementation, the second bit sequence is obtained based on a second check matrix.

In a possible implementation, the first error pattern is obtained by decoding a second code block X based on the second check matrix, where $X = V + (U_1 \cdot G_v + U_2)$, $U_1$ and $U_2$ are subsequences of the first bit sequence U, a length of U is N, a length of $U_2$ is N2, a length of $U_1$ is N1, N=N1+N2, a dimension of $G_v$ is N1×N2, $G_v$ is a generator matrix, and V is the second bit sequence.

In a possible implementation, the first code block is $W = E \cdot H_w$, where $H_w$ is the first check matrix, and E is the first error pattern.

In a possible implementation, the transceiver unit is further configured to receive a third code block from the receiving device. The transceiver unit is further configured to send a check bit sequence to the receiving device, where the check bit sequence is obtained based on a second error pattern and a fourth check matrix, where the second error pattern is obtained based on the first code block and the third code block.

In an example, the third code block may be obtained based on a fifth check matrix and a fourth code block. Optionally, the fourth code block may be a first code block received by the receiving device. The fourth code block may be the same as or different from the first code block.

In an example, the transceiver unit is specifically configured to receive the third code block from the receiving device when the fourth code block is different from the first code block.

In a possible implementation, the check bit sequence is a check bit sequence in the first code block.

In a possible implementation, the third code block is obtained based on the fifth check matrix.

In a possible implementation, when the first bit sequence is an information bit sequence obtained through first encoding, the first code block is obtained based on the first error pattern, the first check matrix, and an error correction capability of the first encoding.

Optionally, when a quantity of errors indicated by the first error pattern is the same as a quantity of errors indicated by the error correction capability of the first encoding, the first code block is not sent.

In a possible implementation, the first check matrix is a check matrix of a BCH code.

In a possible implementation, the first encoding is one of the following: CRC encoding, BCH encoding, RS encoding, RM encoding, polar code encoding, and LDPC encoding.

According to a fourth aspect, a communication apparatus is provided, and includes a processing unit and a transceiver unit.

The transceiver unit is configured to receive a third bit sequence from a sending device. Optionally, the third bit sequence is an information bit sequence, or the third bit sequence is an information bit sequence obtained through first encoding. The processing unit is configured to generate a second bit sequence. The transceiver unit is further configured to send the second bit sequence to the sending device. The transceiver unit is further configured to receive a fourth code block from the sending device, where the fourth code block is obtained based on a first error pattern and a first check matrix. The first error pattern is determined based on the second bit sequence.

In a possible implementation, the second bit sequence is obtained based on a second check matrix.

In an example, the second bit sequence is generated based on the second check matrix and the third bit sequence.

In an example, the transceiver unit is specifically configured to send the second bit sequence to the sending device when a first bit sequence is different from the third bit sequence. Optionally, the first bit sequence is a third bit sequence sent by the sending device. The third bit sequence may be the same as or different from the first bit sequence.

In a possible implementation, the processing unit is further configured to decode the fourth code block based on the first check matrix, to obtain the first error pattern. The receiving device corrects the third bit sequence based on the first error pattern.

In a possible implementation, the transceiver unit is further configured to send a third code block to the sending device. The transceiver unit is further configured to receive a check bit sequence from the sending device, where the check bit sequence is obtained based on a second error pattern and a fourth check matrix, where the second error pattern is obtained based on the fourth code block and the third code block.

In a possible implementation, the check bit sequence is a check bit sequence in the fourth code block.

In a possible implementation, the processing unit is further configured to correct an error of the fourth code block based on the check bit sequence.

In a possible implementation, the third code block is obtained based on a fifth check matrix.

In an example, the third code block may be obtained based on the fifth check matrix and the fourth code block.

In an example, the transceiver unit is specifically configured to send the third code block to the sending device when the fourth code block is different from the first code block. Optionally, the first code block may be a fourth code block sent by the sending device. The fourth code block may be the same as or different from the first code block.

In a possible implementation, when the third bit sequence is an information bit sequence obtained through first encoding, the first code block is obtained based on the first error pattern, the first check matrix, and an error correction capability of the first encoding.

Optionally, when a quantity of errors indicated by the first error pattern is the same as a quantity of errors indicated by the error correction capability of the first encoding, the first code block may not be received.

In a possible implementation, the first check matrix is a check matrix of a BCH code.

In a possible implementation, the first encoding is one of the following: CRC encoding, BCH encoding, RS encoding, RM encoding, polar code encoding, and LDPC encoding.

According to a fifth aspect, this application provides a communication apparatus, including at least one processor. The processor is coupled to a memory. The memory is configured to store a computer program or instructions, and the processor is configured to execute the computer program or the instructions, to perform the implementation methods in the first aspect and the second aspect. The memory may be located inside or outside the apparatus. There are one or more processors.

According to a sixth aspect, this application provides a communication apparatus, including a processor and an interface circuit. The interface circuit is configured to communicate with another apparatus, and the processor is configured to perform the implementation methods in the first aspect and the second aspect.

According to a seventh aspect, a communication apparatus is provided. The apparatus includes a logic circuit and an input/output interface.

In a design, the input/output interface is configured to output a first bit sequence. The first bit sequence is an information bit sequence, or the first bit sequence is an information bit sequence obtained through first encoding. The input/output interface is further configured to input a second bit sequence from a receiving device. The logic circuit is configured to generate a first code block based on a first error pattern and a first check matrix. The first error pattern is determined based on the second bit sequence and the first bit sequence. The input/output interface is further configured to output the first code block to the receiving device.

In a design, the input/output interface is configured to input a third bit sequence from a sending device. The third bit sequence is an information bit sequence, or the third bit sequence is an information bit sequence obtained through first encoding. The logic circuit is configured to generate a second bit sequence. The input/output interface is further configured to output the second bit sequence to the sending device. The input/output interface is further configured to input a fourth code block from the sending device, where the fourth code block is obtained based on a first error pattern and a first check matrix. The first error pattern is determined based on the second bit sequence.

According to an eighth aspect, this application provides a communication system, including a communication apparatus configured to perform the implementation methods in the first aspect and a communication apparatus configured to perform the implementation methods in the second aspect.

According to a ninth aspect, this application further provides a chip system, including a processor, configured to perform the implementation methods in the first aspect and the second aspect.

According to a tenth aspect, this application further provides a computer program product, including computer-executable instructions. When the computer-executable instructions are run on a computer, the implementation methods in the first aspect and the second aspect are performed.

According to an eleventh aspect, this application further provides a computer-readable storage medium. The computer-readable storage medium stores a computer program or instructions. When the instructions are run on a computer, the implementation methods in the first aspect and the second aspect are implemented.

For technical effects achieved in the third aspect to the eleventh aspect, refer to technical effects in the first aspect and the second aspect. Details are not described herein again.

**BRIEF DESCRIPTION OF DRAWINGS**

FIG. 1 is a diagram of a communication system according to an embodiment of this application;
FIG. 2 is a diagram of data transmission between a sending device and a receiving device in a related technology;
FIG. 3 is an example flowchart of an information transmission method according to an embodiment of this application;
FIG. 4A is a diagram of determining a first error pattern by a sending device according to an embodiment of this application;

FIG. 4B is a diagram of determining a first error pattern by a receiving device according to an embodiment of this application;

FIG. 5 is an example flowchart of an information transmission method according to an embodiment of this application;

FIG. 6 is a block diagram of a communication apparatus according to an embodiment of this application;

FIG. 7 is a block diagram of a communication apparatus according to an embodiment of this application;

FIG. 8 is a diagram of a communication apparatus according to an embodiment of this application; and

FIG. 9 is a block diagram of a communication apparatus according to an embodiment of this application.

## DESCRIPTION OF EMBODIMENTS

For ease of understanding of the technical solutions provided in embodiments of this application, the following explains and describes technical terms in embodiments of this application.

(1) Hybrid automatic repeat request (hybrid automatic repeat request, HARQ): a technology formed by combining forward error correction encoding and an automatic repeat request. The HARQ determines, based on an acknowledgment (acknowledgment, ACK) or a negative acknowledgment (non-acknowledgment, NACK), whether retransmission needs to be performed. A sending device sends data to a receiving device. When the receiving device cannot decode the data, the receiving device retains received data, and sends a NACK through a backward channel. The sending device resends the initially transmitted data. After receiving retransmitted data, the receiving device combines the retransmitted data with the initially transmitted data, and then performs decoding.

(2) Syndrome (syndrome): For channel encoding, an encoded sent codeword may be represented as $c = [c_1, c_2, \ldots, c_n]$. The encoded sent codeword arrives at the receiving device after channel transmission. A codeword received by the receiving device may be represented as $r = [r_1, r_2, \ldots, r_n]$. Because errors caused by interference may occur in transmission, r is usually different from c. In a binary communication system, an error pattern may be represented as $e = c \oplus r$, namely, a modulo-2 sum of the sent codeword and the received codeword. It is clear that when c = r, e = 0, indicating that a received sequence is correct. Otherwise, it indicates that a received sequence is incorrect.

By using orthogonality of the codeword and a check matrix H, it may be known that $c \cdot H^T = 0$. Based on this, it may be checked whether the received codeword r is incorrect. In other words, from $r \cdot H^T = (c + e) \cdot H^T = c \cdot H^T + e \cdot H^T = e \cdot H^T$, it may be learned that if e = 0, $e \cdot H^T = 0$, indicating that the received codeword is correct, and if $e \neq 0$, $e \cdot H^T \neq 0$, indicating that the received codeword is incorrect. The syndrome is defined as $S = e \cdot H^T$. In other words, the syndrome S is related to the error pattern, and the receiving device may use whether a value of the syndrome is 0 as a basis for determining whether an error occurs in transmission of a codeword. If the error pattern can be determined from the syndrome S, the receiving device may subtract the error pattern from the received codeword, so that a correct codeword can be obtained.

In embodiments of this application, a plurality of means two or more. The term "and/or" describes an association relationship for describing associated objects and represents that three relationships may exist. For example, A and/or B may represent the following three cases: Only A exists, both A and B exist, and only B exists. The character "/" usually indicates an "or" relationship between the associated objects. In addition, it should be understood that although the terms such as first and second may be used in embodiments of the present invention to describe objects, these objects are not limited by these terms. These terms are merely used to distinguish the objects from each other

Terms "including", "having", and any other variant thereof mentioned in descriptions of embodiments of this application are intended to cover a non-exclusive inclusion. For example, a process, a method, a system, a product, or a device that includes a series of steps or units is not limited to the listed steps or units, but optionally further includes other unlisted steps or units, or optionally further includes another inherent step or unit of the process, the method, the product, or the device. It should be noted that, in embodiments of this application, the word "example" or "for example" is used to represent giving an example, an illustration, or a description. Any embodiment or design scheme described as an "example" or "for example" in embodiments of this application should not be explained as being more preferred or having more advantages than another embodiment or design scheme. Exactly, use of the word "example", "for example", or the like is intended to present a related concept in a specific manner.

The technical solutions provided in embodiments of this application are described below with reference to the accompanying drawings.

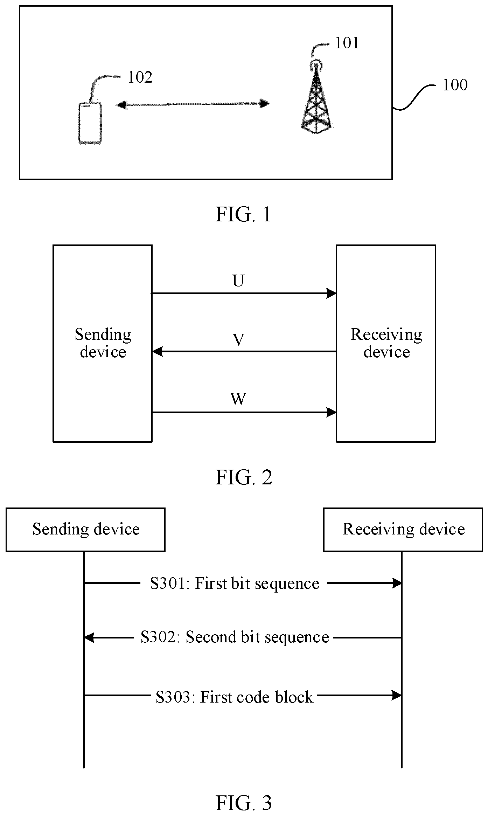

With reference to FIG. 1, the following describes a communication system to which a signal transmission method provided in embodiments of this application is applicable. Refer to FIG. 1. The communication system 100 includes a sending device 101 and a receiving device 102. The sending device 101 may be a network device or a terminal device, and the receiving device 102 may be a network device or a terminal device. Optionally, when the sending device 101 is a network device, the receiving device 102 may be a terminal device. When the receiving device 102 is a network device, the sending device 101 may be a terminal device.

The terminal device in this application includes a device that provides a voice and/or data signal connectivity for a user. Specifically, the terminal device includes a device that provides a voice for the user, a device that provides data signal connectivity for the user, or a device that provides a voice and data signal connectivity for the user. For example, the terminal device may include a handheld device having a wireless connection function or a processing device connected to a wireless modem. The terminal device may include user equipment (user equipment, UE), a wireless terminal device, a mobile terminal device, a device-to-device (device-to-device, D2D) terminal device, a vehicle-to-everything (vehicle-to-everything, V2X) terminal device, a machine-to-machine/machine-type communication (machine-to-machine/machine-type communication, M2M/MTC) terminal device, an internet of things (internet of things, IoT) terminal device, a subscriber unit (subscriber unit), a subscriber station (subscriber station), a mobile station (mobile station), a remote station (remote station), an access point (access point, AP), a remote terminal device (remote terminal), an access terminal device (access terminal), a user terminal device (user terminal), a user agent (user agent), a user device (user device), a satellite, an uncrewed aerial vehicle, a balloon, an airplane, or the like. For example, the terminal device may include a mobile phone (or referred to as a "cellular" phone), a computer having a mobile terminal device, or a portable, pocket-sized, hand-held, or computer built-in mobile apparatus. For example, the terminal device may be a device like a personal communication service (personal communication service, PCS) phone, a cordless telephone set, a session initiation protocol (session initiation protocol, SIP) phone, a wireless local loop (wireless local loop, WLL) station, or a personal digital assistant (personal digital assistant, PDA). The terminal device may further include a limited device, for example, a device with low power consumption, a device with a limited storage capability, or a device with a limited computing capability. For example, the terminal device includes an information sensing device like a barcode, radio frequency identification (radio frequency identification, RFID), a sensor, a global positioning system (global positioning system, GPS), or a laser scanner. By way of example, and not limitation, in embodiments of this application, the terminal device may alternatively be a wearable device. The wearable device may also be referred to as a wearable intelligent device, an intelligent wearable device, or the like, and is a general term for wearable devices developed by intelligently designing everyday wearing by applying a wearable technology. If the various terminal devices described above are located in a vehicle (for example, placed in the vehicle or mounted in the vehicle), the terminal devices may be all considered as in-vehicle terminal devices. For example, the in-vehicle terminal device is also referred to as an on-board unit (on-board unit, OBU).

The network device in this application includes, for example, an access network (access network, AN) device, for example, a base station (for example, an access point), and may be a device that is in an access network and that communicates with a wireless terminal device over an air interface through one or more cells. Alternatively, for example, a network device in a vehicle-to-everything (vehicle-to-everything, V2X) technology is a road side unit (road side unit, RSU). The network device may include an evolved NodeB (NodeB or eNB or e-NodeB, evolved NodeB) in a long term evolution (long term evolution, LTE) system or a long term evolution-advanced (long term evolution-advanced, LTE-A) system, or may include a next generation NodeB (next generation NodeB, gNB) in an evolved packet core (evolved packet core, EPC) network, a 5th generation mobile communication technology (5th generation, 5G), a new radio (new radio, NR) system (also referred to as an NR system for short), or may include a central unit (central unit, CU) and a distributed unit (distributed unit, DU) in a cloud radio access network (cloud radio access network, Cloud RAN) system, a satellite, an uncrewed aerial vehicle, a balloon, an airplane, or the like. This is not limited in embodiments of this application.

Currently, for a manner of retransmitting data between a sending device and a receiving device, refer to FIG. 2. The sending device may send data U to the receiving device. The receiving device sends data V to the sending device. In a related technology, V is usually a 1-bit ACK/NACK. For example, if the receiving device cannot correctly decode U, V may be a NACK. If the receiving device can correctly decode U, V may be an ACK. After receiving the NACK, the sending device may further send data W to the receiving device. The data W may be retransmitted data of the data U.

However, because the data V fed back by the receiving device is usually a 1-bit ACK/NACK, the sending device sends the data W after receiving the NACK. In this case, a data amount of the data W is fixed. For example, the data W may be the initially transmitted data U. In other words, the initially transmitted data is retransmitted each time transmission fails. Consequently, additional transmission overheads are caused.

In view of this, an embodiment of this application provides an information transmission method. In the method, feedback information V of a receiving device is properly designed, and retransmitted information W may be adaptively adjusted based on the feedback information V, to approximate channel capacity.

FIG. 3 is an example flowchart of an information transmission method according to an embodiment of this application. The information transmission method may include the following operations. In the embodiment shown in FIG. 3, a sending device may be a network device or a terminal device, and a receiving device may be a network device or a terminal device. For example, when the sending device is a network device, the receiving device may be a network device or a terminal device. For another example, when the sending device is a terminal device, the receiving device may be a network device or a terminal device.

S301: The sending device sends a first bit sequence to the receiving device.

Correspondingly, the receiving device may receive the first bit sequence from the sending device.

It may be understood that the first bit sequence may be an information bit sequence. For example, the first bit sequence may be a to-be-encoded information bit sequence. Alternatively, the first bit sequence may be an information bit sequence obtained through first encoding. It should be noted that the first encoding is not specifically limited in this embodiment of this application. For example, the first encoding may be one of the following: CRC encoding, BCH encoding, RS encoding, RM, polar (polar) code encoding, or LDPC encoding.

In a possible implementation, the first bit sequence received by the receiving device may be different from the first bit sequence sent by the sending device. For example, an error like inversion or the like may occur in the first bit sequence received by the receiving device. As a result, the first bit sequence received by the receiving device is different from the first bit sequence sent by the sending device. Therefore, for ease of distinguishing, the bit sequence received by the receiving device is referred to as a third bit sequence.

S302: The receiving device sends a second bit sequence to the sending device.

Correspondingly, the sending device receives the second bit sequence from the receiving device.

In a possible implementation, the second bit sequence may be obtained based on a second check matrix. For example, the second check matrix is a check matrix of a BCH code. The receiving device may construct the second check matrix based on parameters of the BCH code: N, K, and $T_{max}$. N represents a bit quantity of the second bit sequence, $T_{max}$ represents a maximum quantity of error corrections, and K represents a bit quantity of information bits. Optionally, $T_{max}$ may be preset, or may be obtained through estimation by the receiving device. It may be understood that the second check matrix may alternatively be obtained based on a generator matrix of a polar code or a generator polynomial of a CRC code. This is not specifically limited in this application.

It should be noted that the sending device and the receiving device may generate a check matrix, for example, the second check matrix, in a predefined or preconfigured manner.

Optionally, the second bit sequence may be a syndrome of the third bit sequence $U_e$. The receiving device may consider the third bit sequence $U_e$ as a codeword, and calculate the syndrome of the third bit sequence. For example, the sending device generates the second bit sequence V based on the second check matrix $H_v$ and the third bit sequence $U_e$. For example, $V = U_e \cdot H_v$.

In another possible implementation, the sending device may determine whether the receiving device accurately receives the first bit sequence. The sending device may determine a first error pattern E based on the second bit sequence. For example, the sending device may decode the second bit sequence based on a second check matrix $H_v$, to obtain the third bit sequence $U_e$. In this way, the sending device may determine the first error pattern E based on the third bit sequence $U_e$ and the first bit sequence.

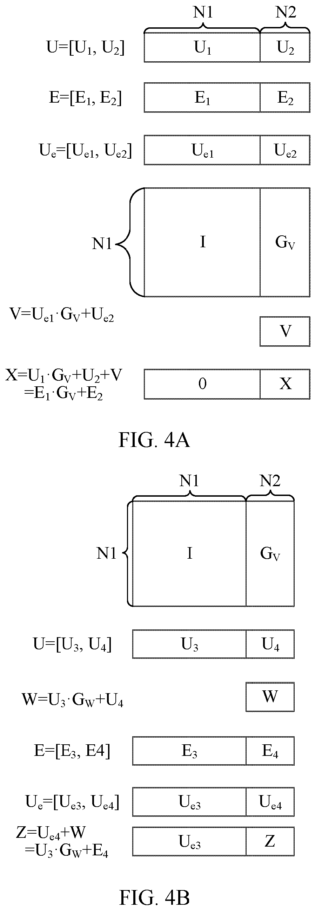

For example, as shown in FIG. 4A, the sending device may set the first bit sequence $U = [U_1, U_2]$, $U_e = [U_{e1}, V_{e2}]$, and $E = [E_1, E_2]$. $U_1$ and $U_2$ are subsequences of the first bit sequence U. $U_{e1}$ and $U_{e2}$ may be subsequences of $U_e$. $E_1$ and $E_2$ may be subsequences of E. In this case, $V = U_e \cdot H_v$ may be converted into:

$$V = U_e \cdot H_v = [U_{e1}, U_{e2}] \cdot H_v = [U_{e1}, U_{e2}] \cdot \begin{bmatrix} G_v \\ I \end{bmatrix} = U_{e1} \cdot G_v + U_{e2}$$

$G_v$ may be a generator matrix, and I may be an identity matrix. If $X = V + (U_1 \cdot G_v + U_2)$, $X = (U_{e1} \cdot G_v + U_{e2}) + (U_1 \cdot G_v + U_2) = E_1 \cdot G_v + E_2$.

It can be learned that $X = E_1 \cdot G_v + E_2 = E \cdot H_v$, in other words, X is a syndrome generated by E.

The sending device may consider X as a codeword, and decode $X = E \cdot H_v$ based on the second check matrix $H_v$, to obtain E. For example, the sending device may decode [0, 0, ... 0, X] to obtain E.

Alternatively, because $X = E_1 \cdot G_v + E_2$, the sending device may decode X based on the second check matrix $H_v$, to obtain $E_1$. The sending device may obtain $E_2$ based on $E_2 = X - E_1 \cdot G_v$. In this way, the sending device may obtain E. Optionally, if the first error pattern E is not completely 0, it may be considered that the receiving device inaccurately receives the first bit sequence. If the first error pattern is completely 0, it may be considered that the receiving device accurately receives the first bit sequence.

Refer to FIG. 4A. It should be noted that a length of U is N, a length of $U_2$ is N2, a length of $U_1$ is N1, and N=N1+N2. A dimension of $G_v$ is N1×N2, and a dimension of I is N1×N1. A length of V, X, $E_2$, or $U_{e2}$ is the same as that of $U_2$, and a length of $E_1$ or $U_{e1}$ is the same as that of $U_1$.

Optionally, when the receiving device accurately receives the first bit sequence, in other words, when the third bit sequence is the same as the first bit sequence, the receiving device may not send the second bit sequence. When the receiving device inaccurately receives the first bit sequence, in other words, when the third bit sequence is different from the first bit sequence, the receiving device may send the second bit sequence. The receiving device may determine, depending on whether the syndrome of the third bit sequence is 0, whether the third bit sequence is accurately received.

S303: The sending device sends a first code block to the receiving device.

Correspondingly, the receiving device receives the first code block from the sending device.

It should be noted that, a manner of generating the first code block varies with different first bit sequences. The following separately uses Case 1 and Case 2 for description.

Case 1: The first bit sequence is an information bit sequence.

The first code block may be obtained based on the first error pattern E and a first check matrix. For example, the first check matrix is a check matrix of the BCH code. The sending device may select BCH (N, K, T) by using the first error pattern E, to obtain the first check matrix $H_w$. The first code block $W = E \cdot H_w$.

The sending device may adjust a size of W by adaptively selecting BCH codes corresponding to different parameters. For example, N=63. The sending device may obtain the first check matrix $H_w$ based on BCH (63, 57, 1), where $H_w$ is a $63 \times 6$ matrix. The sending device obtains W whose size is $1 \times 6$ based on $W = E \cdot H_w$. In other words, a length of W is 6 bits. It may be understood that the 6 bits can be used for correcting one error. In other words, if the first error pattern E indicates that there is one error, the sending device may obtain the first check matrix $H_w$ based on BCH (63, 57, 1). For another example, if the first error pattern E indicates that there are two errors, the sending device may obtain the first check matrix $H_w$ based on BCH (63, 51, 2). In this way, the sending device may obtain W whose length is 12, and the 12 bits can be used for correcting two errors.

The following uses Table 1 to show examples of BCH codes corresponding to different parameters.

**Table 1: Examples of BCH codes**

| T | BCH (63, K, T) for generating W | Length of W: $N_W$=63-K |
|---|---|---|
| 1 | BCH (63, 57, 1) | 6 |
| 2 | BCH (63, 51, 2) | 12 |
| 3 | BCH (63, 45, 3) | 18 |
| 4 | BCH (63, 39, 4) | 24 |
| 5 | BCH (63, 36, 5) | 27 |
| 6 | BCH (63, 30, 6) | 33 |
| 7 | BCH (63, 24, 7) | 39 |
| 8 | BCH (63, 18, 8) | 45 |

It may be understood that Table 1 shows the examples of BCH codes by using N=63 as an example. N may be a bit quantity of the first bit sequence, or may be the bit quantity of the second bit sequence.

It can be learned from Table 1 that when the first error pattern E indicates that there is one error (T=1), the sending device may obtain the first check matrix $H_w$ based on BCH (63, 57, 1). In this case, the length of W may be 6 bits. When the first error pattern E indicates that there are two errors (T=2), the sending device may obtain the first check matrix $H_w$ based on BCH (63, 51, 2). In this case, the length of W may be 12 bits. By analogy, the sending device may adjust a size of the first code block in retransmission based on Table 1 and the first error pattern E. It should be noted that Table 1 shows only the examples of the BCH codes in the case of T=1 to 8. A person skilled in the art may set, in a manner shown in Table 1, an example of a BCH code in the case of T=9 or even a larger value of T.

Simulation shows that on a binary symmetric channel (binary symmetric channel, BSC) (0.015) channel, when channel capacity is 0.8876, an average code rate of the solution in Case 1 may reach 0.8826. In this case, this is equivalent to that a BCH ($N_{avg}$=71.3, 63) code, namely, a short (71.3, 63) code can be used to achieve performance of approximating the channel capacity.

Case 2: The first bit sequence is an information bit sequence obtained through first encoding.

The first code block may be obtained based on the first error pattern, a first check matrix, and an error correction capability of the first encoding. An example in which the first encoding is BCH encoding is used for description. For example, a transmitting end may encode a bit sequence based on a BCH ($N = 63$, $K = 57$, $T_0 = 1$) code, to obtain the first bit sequence. It may be understood that $T_0$ represents a quantity of errors that can be corrected by using a BCH code, and $T_0$ may be preset or may be determined by the sending device.

After obtaining the first error pattern E, the sending device may send $W = E \cdot H_w$ to the receiving device. In this case, the sending device may incrementally send W by using the error correction capability of the first encoding. For example, in previous transmission, a maximum of one error can be corrected in the first bit sequence, but the first error pattern indicates that there are two errors. In this case, the sending device may obtain corresponding $H_w$ based on BCH (63, 51, 2). However, because one error can be corrected in the first transmission, only W whose length is 12-6=6 bits is needed to correct the remaining error.

Optionally, when a quantity of errors indicated by the first error pattern is the same as a quantity of errors indicated by the error correction capability of the first encoding, the sending device may not send the first code block.

The following uses Table 2 to show examples of BCH codes corresponding to different parameters in a case in which W is incrementally sent.

**Table 2: Examples of BCH codes**

| T | BCH (63, K, T) for generating W | Length of W: $N_W$=63-K |
|---|---|---|
| 2 | BCH (63, 51, 2) | 12-6=6 |
| 3 | BCH (63, 45, 3) | 18-6=12 |
| 4 | BCH (63, 39, 4) | 24-6=18 |
| 5 | BCH (63, 36, 5) | 27-6=21 |
| 6 | BCH (63, 30, 6) | 33-6=27 |
| 7 | BCH (63, 24, 7) | 39-6=33 |
| 8 | BCH (63, 18, 10) | 45-6=39 |
| 9 | BCH (63, 18, 10) | 45-6=39 |

It may be understood that Table 2 shows examples of BCH codes by using N=63 as an example. N may be a bit quantity of the first bit sequence, or may be the bit quantity of the second bit sequence.

It can be learned from Table 2 that when the first error pattern E indicates that there are two errors (T=2), because one error can be corrected in the first bit sequence in the previous transmission, the sending device may obtain the first check matrix $H_w$ based on BCH (63, 51, 2). In this case, the length of W may be 6 bits. When the first error pattern E indicates that there are three errors (T=3), because three errors can be corrected in the first bit sequence in the previous transmission, the sending device may obtain the first check matrix $H_w$ based on BCH (63, 45, 3). In this case, the length of W may be 12 bits. By analogy, the sending device may adjust a size of the first code block in retransmission based on Table 2, the first error pattern E, and the error correction capability of the first encoding. It should be noted that Table 2 shows only the examples of the BCH codes when T=2 to 9. A person skilled in the art may set, in a manner shown in Table 2, an example of a BCH code in the case of T=10 or even a larger value of T, and may further set an example corresponding to N of another value and a corresponding different error correction quantity T.

Simulation shows that on a BSC (0.018) channel, when channel capacity is 0.8699, an average code rate of the solution in Case 2 can reach 0.8588. In this case, this is equivalent to that a BCH ($N_{avg}$ =66.4, 57) code, namely, a short (66.4, 57) code can be used to achieve performance of approximating the channel capacity.

In a possible implementation, the receiving device may correct an error of the third bit sequence based on the first code block. For example, the sending device may decode the first code block W based on the first check matrix, to obtain the first error pattern E. The receiving device may correct the error of the third bit sequence based on the first error pattern. For example, the receiving device may obtain the first bit sequence $U = U_e + E$ based on the first error pattern E and the third bit sequence.

Alternatively, as shown in FIG. 4B, the receiving device may set the first bit sequence $U = [U_3, U_4]$, $U_e = [U_{e3}, U_{e4}]$, and $E = [E_3, E_4]$. $U_3$ and $U_4$ are subsequences of the first bit sequence U. $U_{e3}$ and $U_{e4}$ may be subsequences of $U_e$. $E_3$ and $E_4$ may be subsequences of E. In this case, $W = U_3 \cdot G_w + U_4 = E \cdot H_w = E_3 \cdot G_w + E_4$. The receiving device may decode W based on the first check matrix, to obtain $E_3$. Because $E_4 = W - E_3 \cdot G_w$, the receiving device may obtain $E_4$. In this way, the receiving device may obtain the first error pattern E. $G_w$ may be a generator matrix. Alternatively, the receiving device may set $Z=U_{e4}+W=U_3 \cdot G_w+E_4$. The sending device may consider Z as a codeword, and decode Z based on the first check matrix, to obtain $E_4$. Because $E_4 = W - E_3 \cdot G_w$, the receiving device may obtain $E_3$. In this way, the receiving device may obtain the first error pattern E. $G_w$ may be a generator matrix. Refer to FIG. 4B. It should be noted that a length of U is N, a length of $U_4$ is N2, a length of $U_3$ isN1, and N=N1+N2. A dimension of $G_w$ is N1×N2, and a dimension of I is N1×N1. A length of W, Z, $E_4$, or $U_{e4}$ may be the same as that of $U_4$, and a length of $E_3$ or $U_{e3}$ may be the same as that of $U_3$.

According to the foregoing solution, the receiving device may send the second bit sequence to the sending device. In comparison with a current solution, information fed back by the receiving device is no longer limited to a 1-bit ACK or NACK. When capacity of a feedback channel is large enough, in the foregoing solution, the sending device may obtain the error pattern E in the previous transmission through calculation, and adaptively adjust a bit quantity of a retransmitted syndrome based on E. In comparison with a current retransmission solution, a bit quantity in the retransmission can be reduced, channel utilization can be improved, and transmission overheads can be reduced.

In a possible implementation, a first code block received by the receiving device may be different from the first code block sent by the sending device. For ease of distinguishing, the first code block received by the receiving device is referred to as a fourth code block. After receiving the fourth code block $W_e$, the receiving device may send a third code block to the sending device. The third code block may be a syndrome of the fourth code block. For example, the sending device may generate the third code block $Y=W_e \cdot H_V$ based on the second check matrix and the fourth code block. It should be noted that, for implementation of a manner of sending the third code block by the receiving device, refer to the foregoing manner of sending the second bit sequence by the receiving device. Details are not described herein again.

It may be understood that the sending device may determine, based on the third code block, whether the receiving device accurately receives the first code block, in other words, determine whether the first code block is the same as the fourth code block. For implementation of a manner of determining, by the sending device, whether the first code block is the same as the fourth code block, refer to the manner of determining whether the third bit sequence is the same as the first bit sequence by the sending device. Details are not described herein again. If the first code block is different from a second code block, the sending device may determine a second error pattern based on the third code block. It may be understood that the sending device may determine the second error pattern in a manner of determining the first error pattern.

The sending device may send a check bit sequence to the receiving device. For example, when the sending device determines that the first code block is different from the fourth code block, in other words, when the receiving device inaccurately receives the first code block, the sending device may send the check bit sequence to the receiving device. The check bit sequence is obtained based on the second error pattern and a fourth check matrix.

The following uses Table 3 to show examples of BCH codes of the check bit sequence.

**Table 3: Examples of BCH codes**

| T | Length of W: $N_W$=63-K | BCH/sBCH for encoding W |
|---|---|---|
| 1 | 6 | BCH (31, 16) |
| 2 | 12 | BCH (63, 39)--+sBCH (36, 12) |
| 3 | 18 | BCH (63, 18) |
| 4 | 24 | BCH (63, 39)--+sBCH (48, 24) |
| 5 | 27 | BCH (63, 39)--+sBCH (51, 27) |
| 6 | 33 | BCH (63, 51)→sBCH (45, 33) |
| 7 | 39 | BCH (63, 51)→sBCH (51, 39) |
| 8 | 45 | BCH (63, 51)→sBCH (57, 45) |

It may be understood that Table 3 shows examples of BCH codes by using N=63 as an example. N may be the bit quantity of the first bit sequence, or may be the bit quantity of the second bit sequence. In Table 3, sBCH may be understood as a shortened BCH code.

It can be learned from Table 3 that when there is one error (T=1) in the first bit sequence in the previous transmission, the length of the first code block W is 6. In this case, the sending device may select a BCH code in which K is greater than or equal to W, for example, BCH (31, 16) shown in Table 3. For another example, when there are two errors (T=2) in the first bit sequence in the previous transmission, the sending device may select a BCH code in which K is greater than or equal to W, for example, BCH (63, 39) shown in Table 3. However, the length of W is 12. Therefore, values of 39-12=27 bits are 0. Therefore, a shortened BCH code may be used. In the shortened BCH code, N=63-27=36, and K=12, in other words, the shortened BCH code is sBCH (36, 12).

By analogy, the sending device may adjust a size of the check bit sequence based on Table 3 and the length of the first code block W. It should be noted that Table 3 shows only the examples of the BCH codes when T=1 to 8. A person skilled in the art may set, in a manner shown in Table 1, an example of a BCH code in the case of T=9 or even a larger value of T, and may further set an example corresponding to N of another value and a corresponding different error correction quantity T.

It may be understood that Table 1 and Table 3 may be a same table. For example, a fourth column may be added to Table 1, and the added fourth column may be used to store information in a third column in Table 3.

Optionally, the check bit sequence may be a check bit sequence in the first code block, or the check bit sequence may be a check bit sequence in the fourth code block.

It should be noted that Table 3 shows the BCH codes of the check bit sequence in the solution in Case 1. The following uses Table 4 to show BCH codes of the check bit sequence in the solution in Case 2.

**Table 4: Examples of BCH codes**

| T | Length of W: $N_W$=63-K | BCH/sBCH for encoding W |
|---|---|---|
| 2 | 12-6=6 | BCH (31, 16)→sBCH (21, 6) |
| 3 | 18-6=12 | BCH (31, 16)→sBCH (27, 12) |
| 4 | 24-6=18 | BCH (63, 39)--+sBCH (42, 18) |

(continued)

| T | Length of W: $N_W$=63-K | BCH/sBCH for encoding W |
|---|---|---|
| 5 | 27-6=21 | BCH (63, 45)--+sBCH (38, 21) |
| 6 | 33-6=27 | BCH (63, 45)--+sBCH (45, 27) |
| 7 | 39-6=33 | BCH (63, 51)→sBCH (45, 33) |
| 8 | 45-6=39 | BCH (63, 51)→sBCH (51, 39) |
| 9 | 45-6=39 | BCH (63, 51)→sBCH (51, 39) |

It may be understood that Table 4 shows examples of BCH codes by using N=63 as an example. N may be the bit quantity of the first bit sequence, or may be the bit quantity of the second bit sequence. In Table 4, sBCH may be understood as a shortened BCH code.

It can be learned from Table 4 that when there are two errors (T=2) in the first bit sequence in the previous transmission, the length of the first code block W is 6. In this case, the sending device may select a BCH code in which K is greater than or equal to W, for example, BCH (31, 16) shown in Table 4. However, the length of W is 6. Therefore, values of 16-6=10 bits are 0. Therefore, a shortened BCH code may be used. In the shortened BCH code, N=31-10=21, and K=6, in other words, the shortened BCH code is sBCH (21, 6). For another example, when there are three errors (T=3) in the first bit sequence in the previous transmission, the length of the first code block W is 12. In this case, the sending device may select a BCH code in which K is greater than or equal to W, for example, BCH (31, 16) shown in Table 4. However, the length of W is 12. Therefore, values of 16-12=4 bits are 0. Therefore, a shortened BCH code may be used. In the shortened BCH code, N=31-4=27, and K=12, in other words, the shortened BCH code is sBCH (27, 12). By analogy, the sending device may adjust a size of the check bit sequence based on Table 4 and the length of the first code block W. It should be noted that Table 3 shows only the examples of the BCH codes when T=2 to 9. A person skilled in the art may set, in a manner shown in Table 1, an example of a BCH code in the case of T= 10 or even a larger value of T, and may further set an example corresponding to N of another value and a corresponding different error correction quantity T.

It may be understood that Table 2 and Table 4 may be a same table. For example, a fourth column may be added to Table 2, and the added fourth column may be used to store information in a third column in Table 4.

In a possible implementation, the receiving device may correct an error of the fourth code block based on the check bit sequence. For example, the receiving device may generate a BCH code based on the check bit sequence and the third code block, and correct the error of the fourth code block by using the BCH code.

According to the foregoing solution, when the receiving device cannot accurately receive the first code block, the sending device may send the check bit sequence to the receiving device. The receiving device may correct the error of the fourth code block based on the check bit sequence. In this way, the receiving device may determine the first error pattern E based on the fourth code block, so that the first bit sequence can be restored.

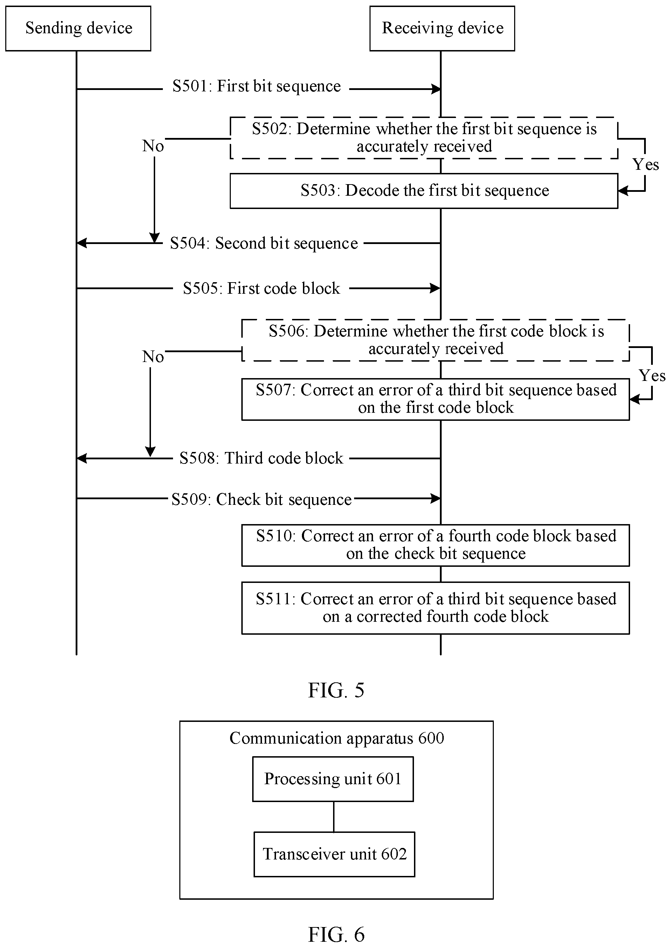

It may be understood that the information transmission method provided in this embodiment of this application may be further applied to an additive white Gaussian noise (additive white gaussian noise, AWGN) scenario. Simulation shows that, in the information transmission method provided in this embodiment of this application, when a signalto-noise ratio EbN0=4.5 dB, a frame error rate (frame error rate, FER)=$10^{-3}$ can be achieved, an average code length is $N_{avg}$=279.7, and a code rate is 0.683. This exceeds a code rate theoretical boundary of 0.66 in a same code length. The following specifically describes, by using FIG. 5, an information transmission method provided in an embodiment of this application. FIG. 5 is an example flowchart of an information transmission method according to an embodiment of this application. The information transmission method may include the following operations.

S501: A sending device sends a first bit sequence to a receiving device.

Correspondingly, the receiving device may receive the first bit sequence from the sending device.

For example, the sending device may send a first bit sequence U to the receiving device. Optionally, the first bit sequence U may be an information bit sequence, or the first bit sequence U may be an information bit sequence obtained through first encoding. S501 may be implemented with reference to S301. For ease of distinguishing, a first bit sequence U received by the receiving device may be referred to as a third bit sequence $U_e$.

Optionally, the embodiment shown in FIG. 5 may further include the following operation S502.

S502: The receiving device determines whether the first bit sequence is accurately received.

For example, the receiving device may determine, depending on whether a syndrome of the third bit sequence $U_e$ is 0, whether the first bit sequence is accurately received. For example, when the syndrome of the third bit sequence $U_e$ is 0, it may be considered that the first bit sequence is accurately received, in other words, the third bit sequence $U_e$ is the same as the first bit sequence U. When the syndrome of the third bit sequence $U_e$ is not 0, it may be considered that the first bit sequence is not accurately received, in other words, the third bit sequence $U_e$ is different from the first bit sequence U.

In an example, when the receiving device does not accurately receive the first bit sequence, S504 may be performed. Optionally, when the receiving device accurately receives the first bit sequence, S503 may be performed.

S503: The receiving device decodes the first bit sequence.

In other words, the receiving device decodes the third bit sequence.

It may be understood that, when the first bit sequence U is an information bit sequence obtained through first encoding, the receiving device may decode the received third bit sequence $U_e$. When the first bit sequence U is an information bit sequence, the receiving device does not need to decode the third bit sequence $U_e$.

S504: The receiving device sends a second bit sequence to the sending device.

The second bit sequence V may be obtained based on a second check matrix, for example, $H_v$. For example, the receiving device may obtain the second bit sequence V based on the second check matrix $H_v$ and the third bit sequence $U_e$. For example, $V = U_e \cdot H_v$.

S504 may be implemented with reference to S302.

In a possible case, the sending device may determine a first error pattern E based on the second bit sequence V For example, the sending device may decode $X = E \cdot H_v$ based on the second check matrix $H_v$, to obtain the first error pattern E. Optionally, when the first error pattern E is not 0, the embodiment shown in FIG. 5 may further include the following operation S505.

S505: The sending device sends a first code block to the receiving device.

Correspondingly, the receiving device receives the first code block from the sending device.

For example, when the first bit sequence is an information bit sequence, the first code block W may be obtained based on the first error pattern E and a first check matrix $H_W$. For another example, when the first bit sequence is an information bit sequence obtained through first encoding, the first code block W may be obtained based on the first error pattern E, a first check matrix $H_W$, and an error correction capability of the first encoding.

S505 may be implemented with reference to S303.

Optionally, the embodiment shown in FIG. 5 may further include the following operation S506.

S506: The receiving device determines whether the first code block is accurately received.

For ease of distinguishing, a first code block W received by the receiving device is referred to as a fourth code block $W_e$. In a possible case, the receiving device may determine, based on a syndrome of the fourth code block, whether the receiving device accurately receives the first code block. For example, the receiving device may generate a third code block $Y = W_e \cdot H_V$ based on the fourth code block $W_e$ and the second check matrix $H_V$. For example, when the syndrome Y of the fourth code block $W_e$ is 0, it may be considered that the fourth code block $W_e$ is accurately received, in other words, the fourth code block $W_e$ is the same as the third code block W. When the syndrome Y of the fourth code block $W_e$ is not 0, it may be considered that the first bit sequence is not accurately received, in other words, the fourth code block $W_e$ is different from the third code block W.

In an example, when the receiving device accurately receives the first code block, S507 may be performed. In another example, when the receiving device does not accurately receive the first code block, S508 may be performed.

S507: The receiving device may correct an error of the third bit sequence based on the first code block.

For example, the sending device may decode the first code block W based on the first check matrix, to obtain the first error pattern E. The receiving device may correct the error of the third bit sequence based on the first error pattern. For example, the receiving device may obtain the first bit sequence $U = U_e + E$ based on the first error pattern E and the third bit sequence.

S507 may be implemented with reference to the manner in which the receiving device corrects the error of the third bit sequence based on the first code block in the embodiment shown in FIG. 3.

S508: The receiving device sends the third code block to the sending device.

Correspondingly, the sending device receives the third code block from the receiving device.

For example, the sending device may generate the third code block $Y = W_e \cdot H_V$ based on the second check matrix and the fourth code block. S508 may be implemented with reference to the manner in which the receiving device sends the third code block to the sending device in the embodiment shown in FIG. 3.

S509: The sending device sends a check bit sequence to the receiving device.

Correspondingly, the receiving device receives the check bit sequence from the sending device.

The check bit sequence is obtained based on a second error pattern and a fourth check matrix. Optionally, the check bit sequence may be a check bit sequence in the first code block, or the check bit sequence may be a check bit sequence in the fourth code block.

S510: The receiving device may correct an error of the fourth code block based on the check bit sequence.

For example, the receiving device may generate a BCH code based on the check bit sequence and the third code block, and correct the error of the fourth code block by using the BCH code.

S511: The receiving device may correct an error of the third bit sequence based on a corrected fourth code block.

For example, the sending device may decode the fourth code block $W_e$ based on the first check matrix, to obtain the first error pattern E. The receiving device may correct the error of the third bit sequence based on the first error pattern. For example, the receiving device may obtain the first bit sequence $U = U_e + E$ based on the first error pattern E and the third bit sequence.

S511 may be implemented with reference to S507.

Based on a concept of the foregoing embodiment, refer to FIG. 6. An embodiment of this application provides a communication apparatus 600. The apparatus 600 includes a processing unit 601 and a transceiver unit 602. The apparatus 600 may be a sending device, or may be an apparatus that is used in a sending device and that can support the sending device in performing an information transmission method. Alternatively, the apparatus 600 may be a receiving device, or may be an apparatus that is used in a receiving device and that can support the receiving device in performing a signal transmission method.

The transceiver unit may also be referred to as a transceiver module, a transceiver, a transceiver machine, a transceiver apparatus, or the like. The processing unit may also be referred to as a processor, a processing board, a processing unit, a processing apparatus, or the like. Optionally, a component that is in the transceiver unit and that is configured to implement a receiving function may be considered as a receiving unit. It should be understood that the transceiver unit is configured to perform a sending operation and a receiving operation on a sending device side or a receiving device side in the foregoing method embodiments. A component that is in the transceiver unit and that is configured to implement a sending function is considered as a sending unit. In other words, the transceiver unit includes the receiving unit and the sending unit. When the apparatus 600 is used in a sending device, the sending unit included in the transceiver unit 602 of the apparatus 600 is configured to perform a sending operation on the sending device side, for example, sending a first bit sequence, and may be specifically sending the first bit sequence to the receiving device. The receiving unit included in the transceiver unit 602 of the apparatus 600 is configured to perform a receiving operation on the sending device side, for example, receiving a second bit sequence, and may be specifically receiving the second bit sequence from the receiving device. When the apparatus 600 is used in the receiving device, the sending unit included in the transceiver unit 602 of the apparatus 600 is configured to perform a sending operation on the receiving device side, for example, sending a second bit sequence, and may be specifically sending the second bit sequence to the sending device. The receiving unit included in the transceiver unit 602 of the apparatus 600 is configured to perform a receiving operation on the receiving device side, for example, receiving a first bit sequence, and may be specifically receiving the first bit sequence from the sending device.

In addition, it should be noted that, if the apparatus is implemented by using a chip/chip circuit, the transceiver unit may be an input/output circuit and/or a communication interface, and perform an input operation (corresponding to the foregoing receiving operation) and an output operation (corresponding to the foregoing sending operation). The processing unit is an integrated processor, a microprocessor, or an integrated circuit.

The following describes in detail an implementation in which the apparatus 600 is used in the sending device or the receiving device.

For example, operations performed by units of the apparatus 600 when the apparatus 600 is used in the sending device are described in detail.

The transceiver unit 602 is configured to send the first bit sequence to the receiving device. The first bit sequence is an information bit sequence, or the first bit sequence is an information bit sequence obtained through first encoding. The transceiver unit 602 is further configured to receive the second bit sequence from the receiving device. The processing unit 601 is configured to generate a first code block based on a first error pattern and a first check matrix, where the first error pattern is determined based on the second bit sequence and the first bit sequence. The transceiver unit 602 is further configured to send the first code block to the receiving device.

In a possible implementation, the transceiver unit 602 is further configured to receive a third code block from the receiving device. The transceiver unit 602 is further configured to send a check bit sequence to the receiving device, where the check bit sequence is obtained based on a second error pattern and a fourth check matrix, where the second error pattern is obtained based on the first code block and the third code block.

In a possible implementation, the transceiver unit 602 is specifically configured to receive the third code block from the receiving device when a fourth code block is different from the first code block.

For example, operations performed by units of the apparatus 600 when the apparatus 600 is used in the receiving device are described in detail.

The transceiver unit 602 is configured to receive a third bit sequence from the sending device. Optionally, the third bit sequence is an information bit sequence, or the third bit sequence is an information bit sequence obtained through first encoding. The processing unit 601 is configured to generate the second bit sequence. The transceiver unit 602 is further configured to send the second bit sequence to the sending device. The transceiver unit 602 is further configured to receive a fourth code block from the sending device, where the fourth code block is obtained based on a first error pattern and a first check matrix. The first error pattern is determined based on the second bit sequence.

In a possible implementation, the transceiver unit 602 is specifically configured to send the second bit sequence to the sending device when the first bit sequence is different from the third bit sequence. Optionally, the first bit sequence is a third bit sequence sent by the sending device. The third bit sequence may be the same as or different from the first bit sequence.

In a possible implementation, the processing unit 601 is further configured to decode the fourth code block based on the first check matrix, to obtain the first error pattern. The receiving device corrects the third bit sequence based on the first error pattern.

In a possible implementation, the transceiver unit 602 is further configured to send a third code block to the sending device. The transceiver unit 602 is further configured to receive a check bit sequence from the sending device, where the check bit sequence is obtained based on a second error pattern and a fourth check matrix, where the second error pattern is obtained based on the fourth code block and the third code block.

In a possible implementation, the processing unit 601 is further configured to correct an error of the fourth code block based on the check bit sequence.

In an example, the transceiver unit 602 is specifically configured to send the third code block to the sending device when the fourth code block is different from the first code block. Optionally, the first code block may be a fourth code block sent by the sending device. The fourth code block may be the same as or different from the first code block.

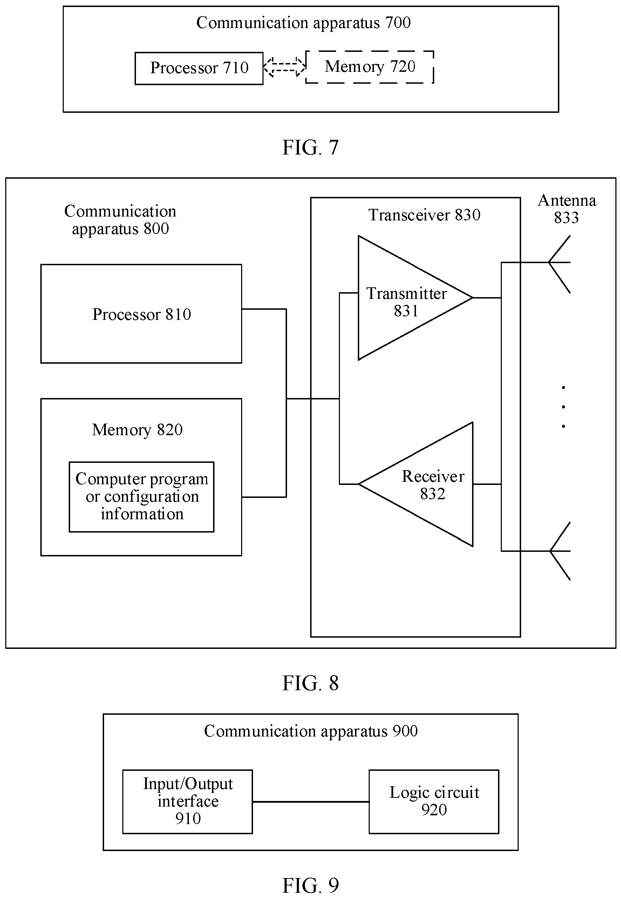

Based on a concept of an embodiment, as shown in FIG. 7, an embodiment of this application provides a communication apparatus 700. The communication apparatus 700 includes a processor 710. Optionally, the communication apparatus 700 may further include a memory 720 for storing instructions executed by the processor 710, input data needed by the processor 710 to run instructions, or data generated after the processor 710 runs instructions. The processor 710 may implement the methods shown in the foregoing method embodiments by using the instructions stored in the memory 720. Optionally, the processor 710 and the memory 720 may be integrated together.

Based on a concept of an embodiment, as shown in FIG. 8, an embodiment of this application provides a communication apparatus 800. The communication apparatus 800 may be a chip or a chip system. Optionally, in this embodiment of this application, the chip system may include a chip, or may include a chip and another discrete component.

The communication apparatus 800 may include at least one processor 810. The processor 810 is coupled to a memory. Optionally, the memory may be located inside the apparatus, or may be located outside the apparatus. For example, the communication apparatus 800 may further include at least one memory 820. The memory 820 stores a necessary computer program, configuration information, a computer program or instructions, and/or data for implementing any one of the foregoing embodiments. The processor 810 may execute the computer program stored in the memory 820, to complete the method in any one of the foregoing embodiments.

The communication apparatus 800 may further include a transceiver 830, and the communication apparatus 800 may exchange information with another device via the transceiver 830. The transceiver 830 may be a circuit, a bus, a transceiver, or any other apparatus that can be configured to exchange information, or is referred to as a signal transceiver unit. As shown in FIG. 8, the transceiver 830 includes a transmitter 831, a receiver 832, and an antenna 833. In addition, when the communication apparatus 800 is a chip type apparatus or circuit, the transceiver in the communication apparatus 800 may alternatively be an input/output circuit and/or a communication interface, and may input data (or is referred to as receiving data) and output data (or is referred to as sending data). The processor is an integrated processor, a microprocessor, or an integrated circuit, and the processor may determine output data based on input data.

The coupling in this embodiment of this application may be an indirect coupling or a communication connection between apparatuses, units, or modules in an electrical form, a mechanical form, or another form, and is used for information exchange between the apparatuses, the units, or the modules. The processor 810 may cooperate with the memory 820. A specific connection medium between the transceiver 830, the processor 810 and the memory 820 is not limited in this embodiment of this application.

In a possible implementation, the communication apparatus 800 may be used in a sending device. Specifically, the communication apparatus 800 may be a sending device, or may be an apparatus that can support a sending device in implementing functions of the sending device in any one of the foregoing embodiments. The memory 820 stores a necessary computer program, a computer program or instructions, and/or data for implementing functions of the sending device in any one of the foregoing embodiments. The processor 810 may execute the computer program stored in the memory 820, to complete the method performed by the sending device in any one of the foregoing embodiments. Used in the sending device, the transmitter 831 in the communication apparatus 800 may be configured to send a first bit sequence through the antenna 833.

In another possible implementation, the communication apparatus 800 may be used in a receiving device. Specifically, the communication apparatus 800 may be a receiving device, or may be an apparatus that can support a receiving device in implementing functions of the receiving device in any one of the foregoing embodiments. The memory 820 stores a necessary computer program, a computer program or instructions, and/or data for implementing functions of the receiving device in any one of the foregoing embodiments. The processor 810 may execute the computer program stored in the memory 820, to complete the method performed by the receiving device in any one of the foregoing embodiments. Used in the receiving device, the receiver 832 in the communication apparatus 800 may be configured to receive a first bit sequence through the antenna 833.

The communication apparatus 800 provided in this embodiment may be used in the sending device, to complete the method performed by the sending device, or may be used in the receiving device, to complete the method performed by the receiving device. Therefore, for technical effects that can be achieved by this embodiment, refer to the foregoing method embodiments. Details are not described herein again.

In this embodiment of this application, the processor may be a general-purpose processor, a digital signal processor, an application-specific integrated circuit, a field programmable gate array, or another programmable logic device, a discrete gate, a transistor logic device, or a discrete hardware component, and may implement or execute the methods, steps, and logical block diagrams disclosed in embodiments of this application. The general-purpose processor may be a microprocessor, any conventional processor, or the like. The steps of the method disclosed with reference to embodiments of this application may be directly performed by a hardware processor, or may be performed by using a combination of hardware in the processor and a software module.

In embodiments of this application, the memory may be a non-volatile memory, for example, a hard disk drive (hard disk drive, HDD) or a solid-state drive (solid-state drive, SSD), or may be a volatile memory (volatile memory), for example, a random-access memory (random-access memory, RAM). Alternatively, the memory may be any other medium that can be configured to carry or store expected program code in a form of an instruction or a data structure and that can be accessed by a computer, but is not limited thereto. The memory in this embodiment of this application may alternatively be a circuit or any other apparatus that can implement a storage function, and is configured to store a computer program, a computer program or instructions, and/or data.

According to the foregoing embodiments, refer to FIG. 9. An embodiment of this application further provides another communication apparatus 900, including an input/output interface 910 and a logic circuit 920. The input/output interface 910 is configured to receive code instructions and perform transmission of the code instructions to the logic circuit 920. The logic circuit 920 is configured to run the code instructions to perform the method performed by the sending device or the method performed by the receiving device in any one of the foregoing embodiments.

The following describes in detail operations performed by the communication apparatus used in the sending device or the receiving device.

In an optional implementation, the communication apparatus 900 may be used in the sending device, to perform the method performed by the sending device, specifically, for example, the method performed by the sending device in the embodiment shown in FIG. 3. The input/output interface 910 is configured to output a first bit sequence. The first bit sequence is an information bit sequence, or the first bit sequence is an information bit sequence obtained through first encoding. The input/output interface 910 is further configured to input a second bit sequence from the receiving device. The logic circuit 920 is configured to generate a first code block based on a first error pattern and a first check matrix. The first error pattern is determined based on the second bit sequence and the first bit sequence. The input/output interface 910 is further configured to output the first code block to the receiving device.

In another optional implementation, the communication apparatus 900 may be used in the receiving device, to perform the method performed by the receiving device, specifically, for example, the method performed by the receiving device in the method embodiment shown in FIG. 3. The input/output interface 910 is configured to input a third bit sequence from the sending device. The third bit sequence is an information bit sequence, or the third bit sequence is an information bit sequence obtained through first encoding. The logic circuit 920 is configured to generate a second bit sequence. The input/output interface 910 is further configured to output the second bit sequence to the sending device. The input/output interface 910 is further configured to input a fourth code block from the sending device, where the fourth code block is obtained based on a first error pattern and a first check matrix. The first error pattern is determined based on the second bit sequence.

The communication apparatus 900 provided in this embodiment may be used in the sending device, to perform the method performed by the sending device, or may be used in the receiving device, to complete the method performed by the receiving device. Therefore, for technical effects that can be achieved by this embodiment, refer to the foregoing method embodiments. Details are not described herein again.

According to the foregoing embodiments, an embodiment of this application further provides a communication system. The system includes at least one communication apparatus used in a sending device and at least one communication apparatus used in a receiving device. For technical effects that can be achieved by this embodiment, refer to the foregoing method embodiments. Details are not described herein again.

According to the foregoing embodiments, an embodiment of this application further provides a computer-readable storage medium. The computer-readable storage medium stores a computer program or instructions. When the instructions are executed, the method performed by the terminal device or the method performed by the network device in any one of the foregoing embodiments is implemented. The computer-readable storage medium may include: any medium that can store program code, like a USB flash drive, a removable hard disk, a read-only memory, a random-access memory, a magnetic disk, or an optical disc.

To implement functions of the communication apparatuses in FIG. 6 and FIG. 9, an embodiment of this application further provides a chip, including a processor, configured to support the communication apparatus in implementing functions of the sending device or the receiving device in the foregoing method embodiments. In a possible design, the chip is connected to a memory, or the chip includes a memory. The memory is configured to store a computer program or instructions and data that are necessary for the communication apparatus.

A person skilled in the art should understand that embodiments of this application may be provided as a method, a system, or a computer program product. Therefore, this application may use a form of hardware only embodiments, software only embodiments, or embodiments with a combination of software and hardware. In addition, this application may use a form of a computer program product that is implemented on one or more computer-usable storage media (including but not limited to a disk memory, a CD-ROM, an optical memory, and the like) that include computer-usable program code.

This application is described with reference to the flowcharts and/or block diagrams of the method, the device (system), and the computer program product according to embodiments of this application. It should be understood that a computer program or instructions may be used to implement each procedure and/or each block in the flowcharts and/or the block diagrams and a combination of a procedure and/or a block in the flowcharts and/or the block diagrams. The computer program or instructions may be provided for a general-purpose computer, a dedicated computer, an embedded processor, or a processor of another programmable data processing device to generate a machine, so that the instructions executed by the computer or the processor of another programmable data processing device generate an apparatus for implementing a specific function in one or more procedures in the flowcharts and/or in one or more blocks in the block diagrams.

The computer program or instructions may alternatively be stored in a computer-readable memory that can instruct the computer or the another programmable data processing device to work in a specific manner, so that the instructions stored in the computer-readable memory generate an artifact that includes an instruction apparatus. The instruction apparatus implements a specified function in one or more procedures in the flowcharts and/or in one or more blocks in the block diagrams.

The computer program or instructions may alternatively be loaded onto the computer or the another programmable data processing device, so that a series of operation steps are performed on the computer or the another programmable device to generate computer-implemented processing. Therefore, the instructions executed on the computer or the another programmable device provide steps for implementing a specific function in one or more procedures in the flowcharts and/or in one or more blocks in the block diagrams.

It is clear that a person skilled in the art can make various modifications and variations to embodiments of this application without departing from the scope of embodiments of this application. In this case, this application is intended to cover these modifications and variations of embodiments of this application provided that they fall within the scope of protection defined by the following claims of this application and their equivalent technologies.

## Claims

1. An information transmission method, comprising:

    sending, by a sending device, a first bit sequence to a receiving device, wherein the first bit sequence is an information bit sequence, or the first bit sequence is an information bit sequence obtained through first encoding;
    receiving, by the sending device, a second bit sequence from the receiving device; and
    sending, by the sending device, a first code block to the receiving device, wherein the first code block is obtained based on a first error pattern and a first check matrix, wherein the first error pattern is determined based on the second bit sequence and the first bit sequence.

2. The method according to claim 1, wherein the second bit sequence is obtained based on a second check matrix.

3. The method according to claim 2, wherein the first error pattern is obtained by decoding a second code block X based on the second check matrix, wherein $X = V + (U_1 \cdot G_v + U_2)$, $U_1$ and $U_2$ are subsequences of the first bit sequence U, a length of U is N, a length of $U_2$ is N2, a length of $U_1$ is N1, N=N1+N2, a dimension of $G_v$ is N1 $\times$ N2, $G_v$ is a generator matrix, and V is the second bit sequence.

4. The method according to claim 3, wherein the first code block is $W = E \cdot H_w$, wherein $H_w$ is the first check matrix, and E is the first error pattern.

5. The method according to any one of claims 1 to 4, further comprising:

    receiving, by the sending device, a third code block from the receiving device; and
    sending, by the sending device, a check bit sequence to the receiving device, wherein the check bit sequence is obtained based on a second error pattern and a fourth check matrix, wherein the second error pattern is obtained based on the first code block and the third code block.

6. The method according to claim 5, wherein the check bit sequence is a check bit sequence in the first code block.

7. The method according to claim 5 or 6, wherein the third code block is obtained based on a fifth check matrix.

8. The method according to any one of claims 1 to 7, wherein when the first bit sequence is an information bit sequence obtained through first encoding, the first code block is obtained based on the first error pattern, the first check matrix, and an error correction capability of the first encoding.

9. The method according to any one of claims 1 to 8, wherein the first check matrix is a check matrix of a Bose Ray-Chaudhuri Hocquenghem BCH code.

10. The method according to any one of claims 1 to 9, wherein the first encoding is one of the following: cyclic redundancy check CRC encoding, BCH encoding, Reed-Solomon RS encoding, Reed-Muller RM encoding, polar code encoding, and low-density parity check LDPC encoding.

11. An information transmission method, comprising:

receiving, by a receiving device, a third bit sequence from a sending device, wherein the third bit sequence is an information bit sequence, or the third bit sequence is an information bit sequence obtained through first encoding;
sending, by the receiving device, a second bit sequence to the sending device; and
receiving, by the receiving device, a fourth code block from the sending device, wherein the fourth code block is obtained based on a first error pattern and a first check matrix, wherein the first error pattern is determined based on the second bit sequence.

12. The method according to claim 11, wherein the second bit sequence is obtained based on a second check matrix.

13. The method according to claim 11 or 12, further comprising:

decoding, by the receiving device, the fourth code block based on the first check matrix, to obtain the first error pattern; and
correcting, by the receiving device, the third bit sequence based on the first error pattern.

14. The method according to claim 12 or 13, further comprising:

sending, by the receiving device, a third code block to the sending device; and
receiving, by the receiving device, a check bit sequence from the sending device, wherein the check bit sequence is obtained based on a second error pattern and a fourth check matrix, wherein the second error pattern is obtained based on the fourth code block and the third code block.

15. The method according to claim 14, wherein the check bit sequence is a check bit sequence in the fourth code block.

16. The method according to claim 14 or 15, further comprising:
correcting, by the receiving device, an error of the fourth code block based on the check bit sequence.

17. The method according to any one of claims 14 to 16, wherein the third code block is obtained based on a fifth check matrix.

18. The method according to any one of claims 11 to 17, wherein when the third bit sequence is an information bit sequence obtained through first encoding, the first code block is obtained based on the first error pattern, the first check matrix, and an error correction capability of the first encoding.

19. The method according to any one of claims 11 to 18, wherein the first check matrix is a check matrix of a Bose Ray-Chaudhuri Hocquenghem BCH code.

20. The method according to any one of claims 11 to 19, wherein the first encoding is one of the following: cyclic redundancy check CRC encoding, BCH encoding, Reed-Solomon RS code encoding, Reed-Muller RM encoding, polar code encoding, and low-density parity check LDPC encoding.

21. A communication apparatus, comprising a unit configured to perform the method according to any one of claims 1 to 10.

22. A communication apparatus, comprising a unit configured to perform the method according to any one of claims 11 to 20.

23. A communication apparatus, comprising at least one processor, wherein the processor is coupled to a memory; and the at least one processor is configured to execute a computer program or instructions stored in the memory, to implement the method according to any one of claims 1 to 10 or the method according to any one of claims 11 to 20.

24. The apparatus according to claim 23, wherein the apparatus further comprises the memory.

25. A communication apparatus, comprising a logic circuit and an input/output interface, wherein

the input/output interface is configured to output a first bit sequence, wherein the first bit sequence is an information bit sequence, or the first bit sequence is an information bit sequence obtained through first encoding; the input/output interface is further configured to input a second bit sequence from a receiving device; the logic circuit is configured to generate a first code block based on a first error pattern and a first check matrix, wherein the first error pattern is determined based on the second bit sequence and the first bit sequence; and the input/output interface is further configured to output the first code block to the receiving device.

26. A communication apparatus, comprising a logic circuit and an input/output interface, wherein

the input/output interface is configured to input a third bit sequence from a sending device, wherein the third bit sequence is an information bit sequence, or the third bit sequence is an information bit sequence obtained through first encoding; the logic circuit is configured to generate a second bit sequence; the input/output interface is further configured to output the second bit sequence to the sending device; and the input/output interface is further configured to input a fourth code block from the sending device, wherein the fourth code block is obtained based on a first error pattern and a first check matrix, wherein the first error pattern is determined based on the second bit sequence.

27. A computer-readable storage medium, wherein the computer-readable storage medium stores a computer program or instructions, and when the instructions are run on a computer, the computer is enabled to implement the method according to any one of claims 1 to 10 or the method according to any one of claims 11 to 20.

28. A computer program product, comprising computer-executable instructions, wherein when the computer-executable instructions are run on a computer, the computer is enabled to perform the method according to any one of claims 1 to 10 or the method according to any one of claims 11 to 20.

29. A communication system, comprising a sending device and a receiving device, wherein the sending device is configured to perform the method according to any one of claims 1 to 10, and the receiving device is configured to perform the method according to any one of claims 11 to 20.

FIG. 1

FIG. 2

FIG. 3

N1        N2

$U=[U_1, U_2]$        | $U_1$ | $U_2$ |

$E=[E_1, E_2]$        | $E_1$ | $E_2$ |

$U_e=[U_{e1}, U_{e2}]$    | $U_{e1}$ | $U_{e2}$ |

N1 {        | $I$ | $G_V$ |

$V=U_{e1} \cdot G_V + U_{e2}$        | $V$ |

$\begin{aligned} X &= U_1 \cdot G_V + U_2 + V \\ &= E_1 \cdot G_V + E_2 \end{aligned}$        | $0$ | $X$ |

FIG. 4A

N1        N2

N1 {        | $I$ | $G_V$ |

$U=[U_3, U_4]$        | $U_3$ | $U_4$ |

$W=U_3 \cdot G_W + U_4$        | $W$ |

$E=[E_3, E4]$        | $E_3$ | $E_4$ |

$U_e=[U_{e3}, U_{e4}]$    | $U_{e3}$ | $U_{e4}$ |

$\begin{aligned} Z &= U_{e4} + W \\ &= U_3 \cdot G_W + E_4 \end{aligned}$        | $U_{e3}$ | $Z$ |

FIG. 4B

FIG. 5

FIG. 6

Communication apparatus 700

Processor 710 <----> Memory 720

FIG. 7

Communication apparatus 800

Processor 810

Memory 820

Computer program or configuration information

Transceiver 830

Transmitter 831

Receiver 832

Antenna 833

FIG. 8

Communication apparatus 900

Input/Output interface 910

Logic circuit 920

FIG. 9

## INTERNATIONAL SEARCH REPORT

International application No.

**PCT/CN2023/088784**

### A. CLASSIFICATION OF SUBJECT MATTER

H04L1/16(2023.01)i

According to International Patent Classification (IPC) or to both national classification and IPC

### B. FIELDS SEARCHED

Minimum documentation searched (classification system followed by classification symbols)

IPC:H04L H03M G06F

Documentation searched other than minimum documentation to the extent that such documents are included in the fields searched

Electronic data base consulted during the international search (name of data base and, where practicable, search terms used)

CNTXT; EXTXT; ENTXTC; VCN; VEN: FEC, 前向纠错编码, 错误图样, 错误, 校验, 矩阵, 编码, 解码, 译码, 重传, code, 循环冗余码校验, CRC, error, decode?, matrix, retransmission, check

### C. DOCUMENTS CONSIDERED TO BE RELEVANT

| Category* | Citation of document, with indication, where appropriate, of the relevant passages | Relevant to claim No. |
|---|---|---|
| X | CN 109428670 A (SANECHIPS TECHNOLOGY CO., LTD.) 05 March 2019 (2019-03-05) claims 1-12, and description, paragraphs 106-161 | 11-12, 18-20, 22-24, 26-29 |
| X | CN 111628780 A (INSTITUTE OF MICROELECTRONICS OF CHINESE ACADEMY OF SCIENCES) 04 September 2020 (2020-09-04) description, paragraphs 40 and 42-144 | 11-12, 18-20, 22-24, 26-29 |
| X | CN 107547169 A (HUAWEI TECHNOLOGIES CO., LTD.) 05 January 2018 (2018-01-05) claims 1-7, and description, paragraphs 95-99 and 122-200 | 11-12, 18-20, 22-24, 26-29 |
| A | CN 111597072 A (INSTITUTE OF MICROELECTRONICS OF CHINESE ACADEMY OF SCIENCES) 28 August 2020 (2020-08-28) entire document | 1-29 |
| A | CN 111917420 A (NEW GENERATION COMMUNICATIONS & NETWORKS INSTITUTE) 10 November 2020 (2020-11-10) entire document | 1-29 |
| A | US 2015007001 A1 (INFINEON TECHNOLOGIES AG) 01 January 2015 (2015-01-01) entire document | 1-29 |

☑ Further documents are listed in the continuation of Box C.   ☑ See patent family annex.

| | |
|---|---|
| * Special categories of cited documents: <br> "A" document defining the general state of the art which is not considered to be of particular relevance <br> "D" document cited by the applicant in the international application <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
|---|---|
| **05 July 2023** | **19 July 2023** |

| Name and mailing address of the ISA/CN | Authorized officer |
|---|---|
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

International application No.

**PCT/CN2023/088784**

**C. DOCUMENTS CONSIDERED TO BE RELEVANT**

| Category* | Citation of document, with indication, where appropriate, of the relevant passages | Relevant to claim No. |
|---|---|---|
| A | WO 2017107904 A1 (HUAWEI TECHNOLOGIES CO., LTD.) 29 June 2017 (2017-06-29) entire document | 1-29 |

**INTERNATIONAL SEARCH REPORT**
**Information on patent family members**

International application No.

**PCT/CN2023/088784**

| Patent document cited in search report | | | Publication date (day/month/year) | Patent family member(s) | | | Publication date (day/month/year) |
|---|---|---|---|---|---|---|---|
| CN | 109428670 | A | 05 March 2019 | None | | | |
| CN | 111628780 | A | 04 September 2020 | None | | | |
| CN | 107547169 | A | 05 January 2018 | EP | 3462652 | A1 | 03 April 2019 |
| | | | | WO | 2018000970 | A1 | 04 January 2018 |
| | | | | US | 2019132086 | A1 | 02 May 2019 |
| CN | 111597072 | A | 28 August 2020 | None | | | |
| CN | 111917420 | A | 10 November 2020 | None | | | |
| US | 2015007001 | A1 | 01 January 2015 | None | | | |
| WO | 2017107904 | A1 | 29 June 2017 | CN | 106899390 | A | 27 June 2017 |

Form PCT/ISA/210 (patent family annex) (July 2022)

**EP 4 503 487 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210431800